# EUROPEAN PATENT APPLICATION

(11) **EP 4 660 221 A1**
(43) Date of publication of application: **10.12.2025**
(21) Application number: 24750187.7
(22) Date of filing: 29.01.2024
(51) Int. Cl.: C08J 5/18, B32B 15/08, B32B 15/082, B32B 27/20, B32B 27/30, C08J 7/00, H01B 5/14, H01Q 1/38, H05K 1/03

(54) **FLUORORESIN SHEET, COPPER-CLAD LAMINATE, CIRCUIT BOARD, AND ANTENNA**

(30) Priority: 31.01.2023 JP 2023012649; 09.11.2023 JP 2023191408
(71) Applicant: Daikin Industries, Ltd., Osaka-shi, Osaka 530-0001 (JP)
(72) Inventor: UEDA, Yuki, Osaka-shi, Osaka 530-0001 (JP); OKUNO, Shingo, Osaka-shi, Osaka 530-0001 (JP); SAWAKI, Kyohei, Osaka-shi, Osaka 530-0001 (JP); HOSOKAWA, Moe, Osaka-shi, Osaka 530-0001 (JP); TANAKA, Yoshito, Osaka-shi, Osaka 530-0001 (JP); KOMATSU, Nobuyuki, Osaka-shi, Osaka 530-0001 (JP); YAMAUCHI, Akiyoshi, Osaka-shi, Osaka 530-0001 (JP); KISHIKAWA, Yosuke, Osaka-shi, Osaka 530-0001 (JP)
(74) Representative: Hoffmann Eitle
(86) International application number: PCT/JP2024/002605
(87) International publication number: WO 2024/162238

(57) **Abstract**

A fluororesin sheet that have achieved both a low coefficient of linear expansion (CTE) and improved adhesiveness to copper foil having a smooth surface, and a copper-clad laminate using the same are obtained.

The fluororesin sheet including a fluororesin and a silica particle, in which one or both surfaces of the fluororesin sheet have an oxygen element percentage of 3.0 atomic% or more as measured by X-ray photoelectron spectroscopy (XPS), and the fluororesin sheet has a coefficient of linear expansion (CTE) of 100 ppm/°C or less.

## Description

### Technical Field

The present disclosure relates to a fluororesin sheet, a copper-clad laminate, a substrate for circuits, and an antenna.

### Background Art

In high-frequency printed wiring boards, those with a low transmission loss have been demanded. In such high-frequency printed wiring boards, fluororesin films are publicly known to be used (Patent Literature 1 and the like).

In such printed wiring boards, attempts have been made to subject the fluororesin film to surface treatment to improve adhesiveness to copper foil.

Patent Literature 2 proposes subjecting a fluororesin film to surface treatment and annealing treatment to achieve favorable adhesiveness to copper foil.

Patent Literature 3 proposes hydrophilizing a surface of a fluororesin substrate to provide a hydrophilization-treated surface with an amino group and a hydroxyl group, thereby improving its adhesiveness to metal foil.

### Citation List

### Patent Literature

Patent Literature 1: Japanese Patent Laid-Open No. 2015-8260
Patent Literature 2: Japanese Patent Laid-Open No. 2022-112028
Patent Literature 3: Japanese Patent Laid-Open No. 2022-114351

### Summary of the Invention

### Technical Problem

An object of the present disclosure is to provide a fluororesin sheet that have achieved both a low coefficient of linear expansion (CTE) and improved adhesiveness to copper foil having a smooth surface, and a copper-clad laminate using the same.

### Solution to Problem

The present disclosure is directed to a fluororesin sheet comprising a fluororesin and a silica particle, wherein one or both surfaces of the fluororesin sheet have an oxygen element percentage of 3.0 atomic% or more as measured by X-ray photoelectron spectroscopy (XPS) and the fluororesin sheet has a coefficient of linear expansion (CTE) of 100 ppm/°C or less.

The fluororesin is preferably polytetrafluoroethylene.

The same surface of the fluororesin sheet preferably further has a nitrogen element percentage of 1.35 atomic% or more as measured by X-ray photoelectron spectroscopy (XPS) .

The same surface of the fluororesin sheet preferably further has a silicon element percentage of 0.5 atomic% or more as measured by X-ray photoelectron spectroscopy (XPS) .

The same surface of the fluororesin sheet preferably further has a static contact angle of water of 105° or less, measured 1 second after a droplet of a volume of 2 µL has been dropped on the surface.

The silica particle is preferably spherical silica.

As the silica particle, a silica particle treated with a silane coupling agent is preferably used.

The silica particle preferably has an average particle size of 10 µm or less.

The fluororesin sheet of the present disclosure is preferably free of a glass fiber.

The content of the silica particle relative to the total amount of fluororesin sheet is preferably 30% by mass or more.

The content of the silica particle relative to the total amount of fluororesin sheet is preferably 50% by mass or more.

The content of the silica particle relative to the total amount of fluororesin sheet is preferably 50% by mass or more and 65% by mass or less.

The fluororesin sheet preferably has a dielectric loss tangent at 10 GHz of 0.0015 or less.

The fluororesin sheet preferably has a thickness of 5 to 250 µm.

The present disclosure is also directed to a method for producing the fluororesin sheet, characterized by including mixing a fluororesin particle and a silica particle to form a film, followed by surface treatment thereof.

Moreover, preferred is the method for producing the fluororesin sheet, including forming a film by using a composition substantially composed of a fluororesin particle and a filler particle containing at least a silica particle, followed by surface treatment thereof.

The present disclosure is also directed to a copper-clad laminate comprising copper foil and the fluororesin sheet as essential layers.

The copper foil preferably has a surface roughness (Rz) of 2.0 µm or less.

The copper foil preferably has a surface roughness (Rq) of 0.01 to 0.15 µm.

It is preferred that the copper foil is directly stacked on the fluororesin sheet, and peel strength of an interface between the copper foil having a surface roughness (Rz) of 2.0 µm or less and the fluororesin sheet is 0.5 kN/m or more.

The present disclosure is also directed to a method for producing the copper-clad laminate, characterized by including stacking the fluororesin sheet and copper foil, heating the stack at 180 to 390°C, and press forming the stack at a pressure of 0.5 to 5 MPa under vacuum or in an inert gas atmosphere.

The present disclosure is also directed to a substrate for circuits, having the copper-clad laminate.

The present disclosure is also directed to an antenna formed of the substrate for circuits.

The antenna is preferably a millimeter wave antenna for mobility applications.

### Advantageous Effects of Invention

The fluororesin sheet of the present disclosure has achieved both a low coefficient of linear expansion (CTE) and improved adhesiveness to copper foil having a smooth surface.

### Description of embodiments

The present disclosure will be described in detail below.

In high-frequency boards of 5G or higher, a smooth interface between a fluororesin sheet and copper foil results in a high-frequency board having a small transmission loss, which is favorable characteristics thereof. Therefore, the fluororesin sheet is required to adhere favorably to the copper foil with a smooth surface.

However, a sheet composed of a single fluororesin has a high coefficient of linear expansion, which may cause warpage of a substrate and defects in a circuit. In particular, a sheet composed of a single polytetrafluoroethylene (PTFE) resin despite of undergoing surface treatment is less likely to form a functional group containing oxygen and the like, resulting in insufficient adhesiveness with copper foil having a smooth surface, which therefore requires further improvement thereon. Such a problem occurs because a functional group is less likely to be created on a surface of the polytetrafluoroethylene resin, and an action whereby the functional group created also facilitates molecular motion, allowing the functional group to move from the surface to an inside of the resin, and is therefore less likely to be exposed on the surface, makes it difficult for the surface to be affected by surface treatment.

In the present disclosure, it have been found that subjecting a surface of a fluororesin sheet containing a fluororesin and a silica particle to surface treatment such as plasma treatment to increase an oxygen element percentage of the surface of fluororesin sheet, have resulted in favorable adhesiveness between the fluororesin sheet and copper foil with a smooth surface of Rz of 2.0 µm or less.

In the present disclosure, subjecting a fluororesin sheet to surface treatment allows a surface of a silica particle contained therein as well to have a functional group due to the surface treatment, making it possible to increase an oxygen atomic percentage of the surface of the fluororesin sheet. This improves adhesiveness between the fluororesin sheet and copper foil, and renders more favorable peel strength of the adhesive surface thereof. Furthermore, in the present disclosure, use of a composite of a fluororesin and a silica particle allows the fluororesin sheet to have a low coefficient of linear expansion.

In such a manner, the fluororesin sheet of the present disclosure can achieve both a low coefficient of linear expansion and favorable peel strength.

The present disclosure is directed to a fluororesin sheet including a fluororesin and a silica particle and having an oxygen element percentage of 3.0 atomic% or more as measured by X-ray photoelectron spectroscopy (XPS) and a coefficient of linear expansion (CTE) of 100 ppm/°C or less. As described above, the fluororesin sheet including a fluororesin and a silica particle, can increase an oxygen element percentage of a surface of the fluororesin sheet, and therefore favorably adhere to copper foil with a smooth surface. Also, for example, the low coefficient of linear expansion (CTE) can sufficiently inhibit warpage of a substrate and defects in a circuit from occurring.

One or both surfaces of the fluororesin sheet of the present disclosure have an oxygen element percentage of 3.0 atomic% or more as measured by X-ray photoelectron spectroscopy (XPS). In particular, a surface of the sheet adhering to copper foil may have an oxygen element percentage of 3.0 atomic% or more as measured by X-ray photoelectron spectroscopy (XPS). The oxygen element percentage of 3.0 atomic% or more allows the fluororesin sheet to bond to a surface of the copper foil, improving the peel strength against the copper foil.

The oxygen atomic percentage is preferably 3.0 atomic% or more, more preferably 5.0 atomic% or more, and still more preferably 10.0 atomic% or more. The upper limit is not specified, but is preferably 25.0 atomic% or less, considering the effect on productivity and other physical properties.

The measurement by X-ray photoelectron spectroscopy (XPS) is specifically performed using a scanning X-ray photoelectron spectroscopy (XPS/ESCA) apparatus PHI5000VersaProbeII (manufactured by ULVAC-PHI, INCORPORATED).

The surface of the fluororesin sheet of the present disclosure having an oxygen element percentage of 3.0 atomic% or more as measured by the above-described X-ray photoelectron spectroscopy (XPS) preferably further has a nitrogen element percentage of 1.35 atomic% or more as measured by X-ray photoelectron spectroscopy (XPS). The nitrogen atomic percentage is more preferably 1.35 atomic% or more, still more preferably 2.5 atomic% or more, and most preferably 3.0 atomic% or more.

In such a manner where the surface of the fluororesin sheet has an increased nitrogen element percentage, contributing to its adhesiveness, sufficient peel strength with copper foil can be obtained without impairing the dielectric properties.

The upper limit thereof is not specified, but is preferably 25.0 atomic% or less, considering the effects on productivity and other physical properties.

The surface of the fluororesin sheet of the present disclosure having an oxygen element percentage of 3.0 atomic% or more as measured by the above-described X-ray photoelectron spectroscopy (XPS) preferably further has a silicon element percentage of 0.5 atomic% or more as measured by X-ray photoelectron spectroscopy (XPS). The silicon atom percentage is more preferably 1.0 atomic% or more, still more preferably 1.5 atomic% or more, and most preferably 2.0 atomic% or more.

In such a manner where the surface of the fluororesin sheet has an increased silicon element percentage, contributing to its adhesiveness, a silica particle that can be surface treated is exposed on the surface, making it possible to increase the peel strength with copper foil.

The upper limit thereof is not specified, but is preferably 10.0 atomic% or less, considering the effects on productivity and other physical properties.

The surface of the fluororesin sheet of the present disclosure having an oxygen element percentage of 3.0 atomic% or more as measured by the above-described X-ray photoelectron spectroscopy (XPS) preferably further has a static contact angle of water of 105° or less, measured 1 second after a droplet of a volume of 2 µL has been dropped on the surface, more preferably 103° or less, and still more preferably 100° or less.

Within such a range satisfied, a new functional group has been created in the fluororesin sheet, increasing the peel strength with copper foil.

The static contact angle of water was measured using a contact angle meter ("DropMaster" manufactured by Kyowa Interface Science Co., Ltd.), as a contact angle against water at 23°C, 1 second after a droplet of a volume of 2 µL had been dropped on the surface.

The fluororesin sheet of the present disclosure has a coefficient of linear expansion (CTE) of 100 ppm/°C or less. Within the above range of CTE, the fluororesin sheet is preferable in terms of having a low shrinkage and excellent dimensional stability.

The upper limit thereof is more preferably 70 ppm/°C, still more preferably 50 ppm/°C, and yet still more preferably 40 ppm/°C. The lower limit thereof is preferably 10 ppm/°C and more preferably 18 ppm/°C.

The coefficient of linear expansion as used herein is determined by making a TMA measurement in a tensile mode with a TMA-7100 (manufactured by Hitachi High-Tech Science Corporation), by using a fluororesin sheet cut to a length of 20 mm, width of 5 mm, and thickness of 150 µm as a sample piece, setting a distance between chucks to 10 mm, and measuring the amount of sample displaced while applying a load of 49 mN at a rate of temperature rise of 2°C/min from 0 to 150°C.

### (Fluororesin)

The fluororesin has low dielectric properties and can therefore be suitably used in the present disclosure.

The fluororesin as can be used in the present disclosure is not limited, but examples thereof include polytetrafluoroethylene (PTFE), a tetrafluoroethylene [TFE]/hexafluoropropylene [HFP] copolymer [FEP], a TFE/alkyl vinyl ether copolymer [PFA], a TFE/HFP/alkyl vinyl ether copolymer [EPA], a TFE/chlorotrifluoroethylene [CTFE] copolymer, a TFE/ethylene copolymer [ETFE], polyvinylidene difluoride [PVdF], and tetrafluoroethylene with a molecular weight of 300,000 or less [LMW-PTFE]. These fluororesin may be used singly or two or more thereof may be mixed and used.

Among these, polytetrafluoroethylene (PTFE) is particularly preferred from the viewpoints of low dielectric properties and a low coefficient of linear expansion. The PTFE preferably is fibrillatable. The PTFE being fibrillatable means a PTFE that can be extruded in paste form from unsintered polymer powder thereof.

The modified PTFE includes a TFE unit based on TFE and a modifying monomer unit based on the modifying monomer. The modifying monomer unit is a portion of the molecular structure of the modified PTFE and is derived from the modifying monomer. The modified PTFE preferably contains a modifying monomer unit in an amount of 0.001 to 0.500% by mass and more preferably 0.01 to 0.30% by mass, of the total monomer unit. The total monomer unit is a portion derived from all monomers in the molecular structure of the modified PTFE.

The modifying monomer is not limited as long as it can be copolymerized with TFE, and examples thereof include a perfluoroolefin such as hexafluoropropylene (HFP); a chlorofluoroolefin such as chlorotrifluoroethylene (CTFE); hydrogen-containing fluoroolefins such as trifluoroethylene and vinylidene difluoride (VDF); perfluorovinyl ether; a perfluoroalkylethylene (PFAE), and ethylene. The modifying monomer to be used may be one type or a plural types thereof.

The perfluorovinyl ether is not limited, and examples thereof include an unsaturated perfluoro compound represented by the following general formula (1):

CF₂=CF-ORf (1)

wherein Rf represents a perfluoro organic group.

The perfluoro organic group as used herein is an organic group in which all hydrogen atoms bonded to carbon atoms are replaced with fluorine atoms. The perfluoro organic group may have an ether oxygen.

An example of the perfluorovinyl ether includes a perfluoro(alkyl vinyl ether) (PAVE) in which Rf in the general formula (1) described above is a perfluoroalkyl group having 1 to 10 carbon atoms. The number of carbon atoms in the perfluoroalkyl group is preferably 1 to 5.

Examples of the perfluoroalkyl group in a PAVE include a perfluoromethyl group, a perfluoroethyl group, a perfluoropropyl group, a perfluorobutyl group, a perfluoropentyl group, and a perfluorohexyl group. A preferred PAVE is perfluoropropyl vinyl ether (PPVE) and perfluoromethyl vinyl ether (PMVE).

The perfluoroalkyl ethylene (PFAE) is not limited, and examples thereof include perfluorobutyl ethylene (PFBE) and perfluorohexyl ethylene (PFHE).

The modifying monomer in the modified PTFE is preferably at least one selected from the group consisting of HFP, CTFE, VDF, a PAVE, a PFAE and ethylene.

The above-described fluororesin is preferably non-melt-processible. The phrase non-melt-processible means that a resin does not have sufficient flowability even when heated at its melting point or higher, and cannot be molded by melt forming techniques commonly used for resins. PTFE corresponds thereto.

In the present disclosure, it is preferable to use such a particle of a non-melt-processible fluororesin and form it into a fluororesin sheet by a forming method for fibrillating the fluororesin. The forming method will be described later.

The PTFE preferably has a standard specific gravity (SSG) of 2.0 to 2.3. The use of such PTFE facilitates a PTFE film having high strength (cohesion strength and puncture strength per unit thickness) to be obtained. PTFE with a large molecular weight has long molecular chains, making it less likely to form a structure of molecular chains regularly arranged. In this case, an amorphous portion elongates, resulting in an increase in the degree of entanglement between molecules. It is considered that the high degree of entanglement between molecules is less likely to allow a PTFE film to deform under an applied load and therefore to exhibit excellent mechanical strength. Also, using PTFE with a large molecular weight facilitates a PTFE film having a small average pore size to be obtained.

The lower limit of the SSG is more preferably 2.05 and still more preferably 2.1. The upper limit of the SSG is more preferably 2.25 and still more preferably 2.2.

The standard specific gravity [SSG] is measured by fabricating a sample in accordance with ASTM D-4895-89 and measuring the specific gravity of the obtained sample by a water displacement method.

The PTFE preferably has a refractive index in the range of 1.2 to 1.6. With such a refractive index, the PTFE has a low dielectric constant, which is preferable in this regard. The refractive index can be adjusted to within the above-described range by a method of adjusting the polarizability or flexibility of the main chain or the like. The lower limit of the refractive index is more preferably 1.25, more preferably 1.30, and most preferably 1.32. The upper limit of the refractive index is more preferably 1.55, more preferably 1.50, and most preferably 1.45.

The refractive index is the value measured using a refractometer (Abbemat 300).

Also, the PTFE preferably has the maximum endothermic peak temperature (crystalline melting point) of 340 ± 7°C.

The PTFE may be low-melting-point PTFE having the maximum peak temperature of 338°C or lower on an endothermic curve on a crystalline melting curve measured by a differential scanning calorimeter, or high-melting-point PTFE having the maximum peak temperature of 342°C or higher on an endothermic curve on a crystalline melting curve measured by a differential scanning calorimeter.

The low-melting-point PTFE powder is powder particles produced by a polymerization using an emulsion polymerization method, and has the maximum endothermic peak temperature (crystalline melting point), a dielectric constant (ε) of 2.08 to 2.2, and a dielectric loss tangent (tan δ) of 1.9 × 10⁻⁴ to 4.0 × 10⁻⁴. Examples of a commercially available product thereof include POLYFLON Fine Powder F201, F203, F205, F301, and F302 manufactured by Daikin Industries, Ltd.; CD090 and CD076 manufactured by Asahi Glass Co., Ltd.; and TF6C, TF62, and TF40 manufactured by Dupont De Nemours Inc.

The high melting point PTFE powder is also powder particles produced by a polymerization using an emulsion polymerization method, and has the above-described maximum endothermic peak temperature (crystalline melting point), a dielectric constant (ε) of 2.0 to 2.1, and a dielectric loss tangent (tan δ) of 1.6 × 10⁻⁴ to 2.2 × 10⁻⁴, which are overall low. Examples of a commercially available product thereof include POLYFLON Fine Powder F104 and F106 manufactured by Daikin Industries, Ltd.; CD1, CD141, and CD123 manufactured by Asahi Glass Co., Ltd.; and TF6 and TF65 manufactured by DuPont De Nemours Inc.

It is to be noted that an average particle size of powder in which both PTFE polymer particles have undergone secondary aggregation is usually preferably 250 to 2,000 µm. In particular, granulated powder obtained by granulation using a solvent is preferred from the viewpoint of improving flowability when filled in a mold upon preliminary forming.

### (Silica particles)

It is essential for the fluororesin sheet of the present disclosure to contain a silica particle.

A shape of the silica particle is not limited, and is particularly preferably spherical. The silica particle of spherical shape is preferable in terms of facilitating uniform processing upon drilling and having a small specific surface area and a low transmission loss. In the present disclosure, it is most preferable to use spherical silica.

The spherical silica particle refers to a particle, the shape of which is close to a perfect sphere. Specifically, the sphericity is preferably 0.80 or more, more preferably 0.85 or more, still more preferably 0.90 or more, and most preferably 0.95 or more. The sphericity is calculated by taking a photograph of the particle with an SEM and calculating a value from an area and an perimeter of the particle observed, by formula : (sphericity) = {4π × (area)/(perimeter)2}. The closer the sphericity is to 1, the closer the particle is to a perfect sphere. Specifically, an average value measured for 100 particles is adopted using an image processing device (FPIA-3000 manufactured by Spectris PLC).

Also, each parameter of the spherical silica can also be measured by the aforementioned method for having heated the fluororesin sheet at 600°C for 30 minutes in an air atmosphere to burn off the fluororesin and extract spherical silica particles.

The silica particle is preferably a particle that has been subjected to surface treatment. Subjecting them to preliminary surface treatment results in an interaction between the silica particles, making it possible to reduce the coefficient of linear expansion of the fluororesin sheet.

The surface treatment described above is not limited, and any known surface treatment can be employed. Specific examples thereof include treatment with silane coupling agents such as epoxy silane having a reactive functional group, amino silane, isocyanate silane, vinyl silane, acrylic silane, hydrophobic alkyl silane, phenyl silane, and fluorinated alkyl silane, plasma processing, and fluorination treatment. Among them, it is preferable to perform treatment with a silane coupling agent.

In the present disclosure, it is preferable to use a silica particle treated with a silane coupling agent. The treatment of silica particle with a silane coupling agent enables a coefficient of linear expansion of fluororesin sheet to be reduced, which is advantageous in terms of improving the adhesion of fluororesin sheets to copper foil. Also, by treating it with a silane coupling agent, a polar functional group present on a surface of the silica particle is reacted to reduce the amount of polar functional group, resulting in a silica particle having excellent electrical characteristics. Furthermore, a reaction of a functional group contained in the silane coupling agent with a surface of copper foil further enhances the peel strength with the copper foil.

Examples of the silane coupling agent include epoxy silanes such as γ-glycidoxypropyltriethoxysilane and β-(3,4-epoxycyclohexyl)ethyltrimethoxysilane, amino silanes such as aminopropyltriethoxysilane and N-phenylaminopropyltrimethoxysilane, isocyanate silane such as 3-isocyanatopropyltrimethoxysilane, vinyl silane such as vinyltrimethoxysilane, and acrylic silane such as acryloxytrimethoxysilane.

An average particle size of the silica particles is preferably 10 µm or less. The average particle size of the silica particles of 10 µm or less reduces the surface roughness of the sheet, which is preferable.

The upper limit of the average particle size of the silica particles is more preferably 8 µm or less and still more preferably 5 µm or less.

Also, the lower limit of the average particle size of the silica particles is not limited, and is preferably 0.5 µm or more. The average particle size thereof of less than 0.5 µm causes aggregation of filler, so that the sufficient effect tends not to be obtained.

It is to be noted that the average particle size as used herein is the D50 value measured by a laser analysis particle size distribution analyzer.

For example, the silica particle to be used may be a commercially available silica particle that satisfies the aforementioned properties. Examples of the commercially available silica particle include DENKA FUSED SILICA FB grade (manufactured by Denka Company Limited), DENKA FUSED SILICA SFP grade (manufactured by Denka Company Limited), EXCELICA (manufactured by Tokuyama Corporation), high-purity synthetic spherical silica particles ADMAFINE (manufactured by Admatechs Co., Ltd.), ADMANANO (manufactured by Admatechs Co., Ltd.), and ADMAFUSE (manufactured by Admatechs Co., Ltd.).

The content of the silica particles is preferably 30% by mass or more relative to the total amount of fluororesin sheet. Such an amount of silica particles compounded is preferable in terms of capable of reducing a coefficient of linear expansion while maintaining a low dielectric constant and a low loss. Also, when used as the fluororesin, PTFE is unlikely to form oxygen and nitrogen functional groups in spite of plasma treatment; however, the presence of silica particles allows the silica surface to also have a functional group derived from by the surface treatment. As a result, the oxygen atom percentage of a surface of the fluororesin sheet can be increased, resulting in the favorable adhesiveness between the fluororesin sheet and copper foil and the favorable peel strength of the adhesive surface.

The amount of silica particle compounded is more preferably 35% by mass or more, still more preferably 50% by mass or more, and yet still more preferably 55% by mass or more. The upper limit of the amount of silica particle compounded is not limited, and is preferably 70% by mass or less, more preferably 68% by mass or less, and still more preferably 65% by mass or less.

### (Sheet)

The fluororesin sheet of the present disclosure preferably has a dielectric loss tangent at 10 GHz of 0.0015 or less. Within the above range of the dielectric loss tangent, the fluororesin sheet is preferable in terms of capable of keeping a loss of an electrical signal in a circuit low. The dielectric loss tangent is more preferably 0.0012 or less and still more preferably 0.0011 or less. The lower limit of the dielectric loss tangent is, on the other hand, preferably 0.00001.

The fluororesin sheet of the present disclosure preferably has a dielectric constant at 10 GHz of 3.5 or less. Within the above range of the dielectric constant, the fluororesin sheet is preferable in terms of having a low dielectric loss.

The upper limit of the dielectric constant is more preferably 3.2 and still more preferably 3.1. The lower limit of the dielectric constant is, on the other hand, preferably 2.0 and more preferably 2.5.

The dielectric constant (Dk) and dielectric loss tangent (Df) at 10 GHz as used herein were determined by measuring Dk and Df at 25°C and 10 GHz using a split-cylinder type dielectric constant/dielectric loss tangent measurement apparatus (manufactured by EM Labs, Inc.).

The fluororesin sheet of the present disclosure preferably has a thickness of 5 to 250 µm. The lower limit of the thickness is more preferably 15 µm or more and still more preferably 30 µm or more. The upper limit of the thickness is more preferably 230 µm or less and still more preferably 200 µm or less. The thickness can be selected, considering a balance between electrical characteristics of a laminate and the coefficient of linear expansion, and the like.

For example, the fluororesin sheet of the present disclosure may contain a component other than the fluororesin and silica particle. The component to be contained is not limited, and examples thereof can include a thermosetting resin and a thermoplastic resin, which are free of fluorine.

It is to be noted that the fluororesin sheet of the present disclosure preferably is free of a glass fiber. The fluororesin sheet being free of a glass fiber or cloth composed of a glass fiber, can be made thin, and also becomes more flexible, as a result of which the fluororesin sheet has an advantage of being easily used in applications where it is used while being bent.

In the present disclosure, a filler other than the silica particle may be used as long as it does not impair the purpose of the present disclosure.

### (Method for producing fluororesin sheet)

The fluororesin sheet of the present disclosure can be obtained, for example, by mixing the aforementioned fluororesin particle and the silica particle to form a film, followed by surface treatment thereof. The forming method of a film is not limited, and paste extrusion forming, powder rolling forming, or the like can be employed.

As described above, it is preferable to use, as the fluororesin particle to be used in the fluororesin sheet of the present disclosure, a non-melt-processible fluororesin particle. In the case of such a fluororesin particle to be used, it is preferable to form it into a sheet by fibrillating powdered PTFE as a raw material.

It is preferable to use the powdered PTFE having a primary particle size of 0.05 to 10 µm. Using such powder has an advantage of excellent moldability and dispersibility. It is to be noted that the primary particle size as used herein is a value measured in accordance with ASTM D 4895.

The powdered PTFE contains a polytetrafluoroethylene resin having a secondary particle size of 500 µm or more in an amount of preferably 50% by mass or more and more preferably 80% by mass or more. The PTFE having a secondary particle size of 500 µm or more within the above range, has an advantage of being capable of fabricating a fluororesin sheet with high strength.

Using the PTFE having a secondary particle size of 500 µm or more enables a sheet with lower resistance and greater toughness to be obtained.

The lower limit of the secondary particle size is more preferably 300 µm and still more preferably 350 µm. The upper limit of the secondary particle size is more preferably 700 µm or less and still more preferably 600 µm or less. The secondary particle size can be determined, for example, by a sieving method or the like.

The powdered PTFE described above can provide a sheet with higher strength and excellent homogeneity, so that an average primary particle size thereof is preferably 50 nm or more, more preferably 100 nm or more, still more preferably 150 nm or more, and particularly preferably 200 nm or more.

The larger the average primary particle size of PTFE is, the more inhibited an increase in paste extrusion pressure upon paste extrusion forming using the powder will be, resulting in excellent moldability. The upper limit of the average primary particle size of PTFE is not limited, but it may be 500 nm. From the viewpoint of productivity in a polymerization process, it is preferably 350 nm.

The average primary particle size can be determined by preparing a calibration curve of a transmission of projected light of 550 nm relative to a unit length of an aqueous dispersion obtained by using an aqueous dispersion of PTFE obtained by polymerization and adjusting its polymer concentration to 0.22% by mass, and an average primary particle size determined by measuring an unidirectional diameter of the particle observed in a photograph of the particle by a transmission electron microscope, and then measuring the transmission of the aqueous dispersion to be measured, based on the calibration curve.

The PTFE particle to be used in the present disclosure may have a core-shell structure. An example of the PTFE particle having a core-shell structure includes modified polytetrafluoroethylene which contains a core of high molecular weight polytetrafluoroethylene in the particle and a shell of lower molecular weight polytetrafluoroethylene or modified polytetrafluoroethylene. An example of such modified polytetrafluoroethylene includes the polytetrafluoroethylene described in Japanese Translation of PCT International Application Publication No. 2005-527652.

Specific methods of paste extrusion forming and powder rolling forming are not limited, and a general method will be described below.

### (Paste extrusion forming)

A method for producing the fluororesin sheet may include the steps of (1a) mixing a powdered fluororesin particle obtained using a hydrocarbon surfactant, a silica particle, and an auxiliary agent for extrusion, (1b) subjecting the mixture obtained to paste extrusion forming, (1c) rolling the extrudate obtained by extrusion forming, (1d) drying the rolled sheet, and (1e) sintering the dried sheet to obtain a formed article.

The paste extrusion forming may also be performed by adding conventionally and publicly known additives such as a pigment or a filler to the fluororesin particle and silica particle.

The auxiliary agent for extrusion is not limited, and any publicly known agent may be used. Examples thereof include hydrocarbon oil and the like.

### (Powder rolling forming)

The fluororesin sheet can also be formed by powder rolling forming. The powder rolling forming is a method for applying shear force to a powdered fluororesin particle followed by fibrillation thereof, and thus forming it into a sheet. This method may include the step of sintering the sheet thereafter to obtain a formed article.

More specifically, the fluororesin sheet can be obtained by a production method including
step (1) of applying shear force while mixing a raw material composition containing a fluororesin particle and a filler particle,
step (2) of forming the mixture obtained by step (1) above into a bulk form, and
step (3) of rolling the mixture in bulk form obtained by step (2) above into a sheet,
and the like.

Furthermore, the method may include step (4) of sintering the formed article in sheet form obtained above at 200 to 400°C for 1 to 60 minutes.

Also, step (2) may be omitted.

In the case of a fluororesin sheet to be produced by the powder rolling forming method, it is preferable to form a film using a composition that is free of a liquid component and is substantially composed of a fluororesin particle and a filler particle containing at least a silica particle. The phrase "substantially composed of a fluororesin particle and a filler particle containing at least a silica particle" means that the content of a component other than the fluororesin particle and filler particle is 3% by mass or less based on the total amount of composition.

The filler particle contains at least a silica particle, and another filler particle is preferably aluminum oxide, zinc oxide, titanium oxide, calcium carbonate, magnesium oxide, or the like. Also, the filler particle other than the silica particle may not be used, or one type thereof may be used, or two or more thereof may be mixed and used. The filler particle other than the silica particle preferably accounts for 0.1 to 80% by mass of the filler particle.

In particular, it is preferable to mix only the fluororesin particle and the silica particles followed by forming thereof.

At least a surface to be treated of the fluororesin sheet before surface treatment obtained by the method for producing the fluororesin sheet, preferably has an oxygen element percentage of 1.5 atomic% or more as measured by X-ray photoelectron spectroscopy (XPS). The surface of the fluororesin sheet before surface treatment such that the oxygen element is present enables favorable adhesion to copper foil having a smooth surface. Such a range is preferable in order for an oxygen element percentage in the fluororesin sheet after surface treatment, as measured by X-ray photoelectron spectroscopy (XPS) to also fall in a specific range.

The oxygen atomic percentage is preferably 1.65 atomic% or more, more preferably 1.7 atomic% or more, and still more preferably 1.8 atomic% or more. The upper limit is not specified, but is preferably 4.9 atomic% or less, considering the effects on productivity and other physical properties.

A method for making the oxygen element percentage of the fluororesin sheet before surface treatment to stay in the above range is not limited, and the oxygen element percentage may be controlled, for example, by adjusting the amount of silica particle compounded or a forming method.

At least a surface to be treated of the fluororesin sheet before surface treatment preferably has a silicon element percentage of 0.2 atomic% or more as measured by X-ray photoelectron spectroscopy (XPS). The surface of the fluororesin sheet before surface treatment such that the silicone element is present enables favorable adhesion to copper foil having a smooth surface. Such a range is also preferable in order for a silicon element percentage of the fluororesin sheet after surface treatment, as measured by X-ray photoelectron spectroscopy (XPS), to be 0.5 atomic% or more.

The silicon element percentage is preferably 0.3 atomic% or more, more preferably 0.5 atomic% or more, and still more preferably 0.7 atomic% or more. The upper limit thereof is not limited, and is preferably 2.0 atomic% or less in consideration of the effects on productivity and other physical properties.

In order to make the silicon element percentage of the fluororesin sheet before surface treatment to fall within the above range, the amount of silica particle compounded may be adjusted, for example.

### (Surface treatment)

One or both surfaces of the fluororesin sheet obtained by such a method described above underwent surface treatment under appropriate conditions, enables the fluororesin sheet to be made into a fluororesin sheet that satisfies the above requirements.

A fluororesin is generally a material that is difficult to adhere to copper foil. For this reason, in the present disclosure, the fluororesin sheet is subjected to surface treatment in order to improve lamination characteristics. Such surface treatment is generally known to be a method for increasing the amount of oxygen atom in a resin surface.

A specific method of the surface treatment is not limited, and any known method can be employed.

The surface treatment of the fluororesin sheet can employ conventional discharge treatment such as plasma discharge treatment, corona discharge treatment, glow discharge treatment, and sputtering treatment. Among them, the plasma treatment is suitable.

The plasma treatment is treatment whereby a fluororesin on an outer surface of a fluororesin sheet is etched by bringing the fluororesin sheet into contact with plasma, to impart an oxygen atom, a nitrogen atom, and the like to the outer surface of the fluororesin sheet.

For example, introducing oxygen gas, nitrogen gas, hydrogen gas, helium gas, argon gas, or the like into a discharge atmosphere enables the surface free energy to be controlled.

Alternatively, surface treatment may be carried out by exposing a surface to be modified to an atmosphere of organic compound-containing inert gas, which is inert gas containing an organic compound, applying a high-frequency voltage between electrodes to cause a discharge followed by generating active species on the surface, and then introducing a functional group of the organic compound or graft-polymerizing a polymerizable organic compound.

An example of an organic compound in the organic compound-containing inert gas includes a polymerizable or non-polymerizable organic compound containing an oxygen atom, such as vinyl esters such as vinyl acetate and vinyl formate; acrylate such as glycidyl methacrylate; ethers such as vinyl ethyl ether, vinyl methyl ether, and glycidyl methyl ether; carboxylic acids such as acetic acid and formic acid; alcohols such as methyl alcohol, ethyl alcohol, phenol, and ethylene glycol; ketones such as acetone and methyl ethyl ketone; carboxylic esters such as ethyl acetate and ethyl formate; and acrylic acids such as acrylic acid and methacrylic acid. Among these, in terms of a modified surface that is less likely to be deactivated, i.e., the surface which has a long life and facilitates its handling in terms of safety, the vinyl esters, acrylates, and ketones are preferred, and vinyl acetate and glycidyl methacrylate are particularly preferred.

A concentration of the organic compound in the organic compound-containing inert gas varies depending on the type of organic compound and a type of fluororesin to be surface treated, but is usually 0.1 to 3.0% by volume, preferably 0.1 to 1.0% by volume, more preferably 0.15 to 1.0% by volume, and still more preferably 0.30 to 1.0% by volume. The discharge conditions may be appropriately selected depending on a degree of surface treatment of a target, the type of fluororesin, and the type of organic compound and its concentration. Usually, the discharge treatment is carried out in an amount of discharge in the range of 50 W·min/m² or more and 1500 W·min/m² or less and preferably 70 W·min/m² or more and 1400 W·min/m² or less. The treatment can be arbitrarily carried out at a treatment temperature in the range of 0°C or higher and 100°C or lower. The temperature is preferably 80°C or lower due to concerns about elongation and wrinkles of the fluororesin sheet.

The fluororesin sheet of the present disclosure, which has been surface treated as described above, can be used by being stacked with another substrate as a sheet of a substrate for circuits.

It may be used as a laminate in which copper foil have adhered to one or both surfaces of the aforementioned fluororesin sheet.

The present disclosure is also directed to a copper-clad laminate, which is composed of copper foil and the aforementioned fluororesin sheet as essential layers. As described above, the fluororesin sheet containing the fluororesin and silica particle of the present disclosure has excellent adhesiveness. Therefore, it is preferably a laminate in which copper foil is directly stacked on a surface-treated surface of the fluororesin sheet of the present disclosure.

The copper foil preferably has a surface roughness (Rz) of 2.0 µm or less. The surface roughness (Rz) of 2.0 µm or less results in a smooth interface between copper foil and the fluororesin sheet, high metal interface electrical conductivity, and a low transmission loss, which are preferable.

At least a surface of the copper foil, which adheres to the aforementioned fluororesin sheet may have Rz of 2.0 µm or less, and the other surface of the copper foil may have Rz which is not limited.

The fluororesin sheet of the present disclosure has excellent adhesiveness to copper foil having a high smoothness of Rz of 2.0 µm or less, further Rz of 1.0 µm or less, and even further Rz of 0.5 µm or less.

The Rz is the sum of a value of the highest portion (maximum peak height: Rp) and a value of the deepest portion (maximum valley depth: Rv). The Rz is a ten-point average roughness stipulated in JIS-B0601. The Rz as used herein is the value measured using a surface roughness meter (product name: SURFCOM 470A, manufactured by Tokyo Seimitsu Co., Ltd.) with a measurement length of 4 mm.

The copper foil preferably has a surface roughness (Rq) of 0.01 to 0.15 µm.

Within the above range of Rq, metal interface electrical conductivity can be increased and a transmission loss can be favorably reduced, which is preferred.

At least a surface of the copper foil, which adheres to the fluororesin sheet may have Rq of 0.01 to 0.15 µm and the other surface may have Rq which is not limited. Rq of the surface that adheres to the fluororesin sheet is more preferably 0.015 to 0.1 µm and still more preferably 0.03 to 0.08 µm.

The above-described Rq is a root mean square height. In the present description, the above-described Rq is the value measured using a stylus surface roughness measuring instrument (product name: SE600A, manufactured by Kosaka Laboratory Ltd.) with a measurement length of 4 mm.

A thickness of the copper foil is not limited, and is preferably 1 to 100 µm, more preferably 5 to 50 µm, and still more preferably 9 to 35 µm.

The copper foil is not limited, and specific examples thereof include rolled copper foil and electrolytic copper foil.

The copper foil having an Rz of 2.0 µm or less and/or an Rq of 0.01 to 0.15 µm is not limited, and commercially available products can be used. An example of commercially available copper foil includes electrolytic copper foil CF-T9DA-SV-18 (thickness 18 µm/Rz 0.85 µm/Rq 0.05 µm) (manufactured by Fukuda Metal Foil Powder Co., Ltd.).

The copper foil may also be surface-treated in order to increase its peel strength with the fluororesin sheet of the present disclosure.

In the case of the copper-clad laminate of the present disclosure in which copper foil is directly stacked on a surface-treated surface of the fluororesin sheet, the peel strength of an interface between the copper foil and the fluororesin sheet is preferably 0.5 kN/m or more.

Using the fluororesin sheet of the present disclosure enables the above-described peel strength to be realized.

The peel strength 0.5 kN/m or more allows the fluororesin sheet to be suitably used as a copper-clad laminated board or a substrate for circuits. The peel strength is preferably 0.7 kN/m or more.

The upper limit of the peel strength is not limited, and may be 3.0 kN/m or less.

It is to be noted that the peel strength as used herein refers to the peel strength measured under the conditions described in Examples.

Also, in the case of a laminate in which copper foil adheres to a surface-treated surface of the fluororesin sheet that has been surface-treated on one surface only, the surface of the fluororesin sheet which has not been surface treated may be surface-treated separately in order to improve adhesiveness between the laminate and another material.

For example, the copper-clad laminate of the present disclosure may further have a layer other than the copper foil and the fluororesin sheet.

In the copper-clad laminate of the present disclosure, a copper foil layer may be formed on one or both surfaces of a rolled sheet. Examples of a method for forming the copper foil layer include a method for stacking (adhering) copper foil on a surface of the rolled sheet, a vapor deposition method, a plating method, and the like.

An example of the method for stacking copper foil includes a method using heat press and the like. An example of a heat press temperature upon heat press includes a temperature between the melting point of the sheet -150°C and the melting point of the sheet +40°C. A heat press time is, for example, 1 to 30 minutes.

For example, suitable is a method for producing a copper-clad laminate including stacking the fluororesin sheet and copper foil, heating the stack at 180 to 390°C, and press forming the stack at a pressure of 0.5 to 5 MPa under a vacuum or in an inert gas atmosphere.

The press forming under such conditions prevents deterioration of the fluororesin sheet and allows for adhesion to copper foil.

In obtaining the configuration of the aforementioned laminate, the fluororesin sheet of the present disclosure is to be used with copper foil allowed to adhere to one or both surfaces of the fluororesin sheet. As described above, the fluororesin sheet of the present disclosure has excellent adhesiveness. Therefore, it also has excellent adhesiveness to copper foil having a high smoothness of Rz of 2.0 µm or less.

Copper foil to be used in a substrate for circuits conventionally has a certain degree of unevenness imparted on its surface in order to ensure adhesiveness to the fluororesin sheet. However, in high-frequency applications, the presence of unevenness on a surface of the copper foil causes a loss of an electrical signal, which is thereby not preferable. The laminate described above can obtain suitable adhesiveness even to copper foil having a high smoothness, and is a laminate that can be suitably used as a substrate for circuits.

The use of the copper-clad laminate of the present disclosure is not limited, and it is used as a substrate for circuits. The present disclosure is also directed to a substrate for circuits having the copper-clad laminate described above.

The copper-clad laminate of the present disclosure is also used as a substrate for circuits, so that the metal interface electrical conductivity is preferably high. It is preferably 1.00 (1e7 S/m) or more, more preferably 3.00 (1e7 S/m) or more, and still more preferably 5.00 (1e7 S/m) or more. The upper limit thereof is not limited, and is preferably 6.00 (1e7 S/m) or less.

The copper-clad laminate of the present disclosure is also used as a substrate for circuits, so that the transmission loss is preferably close to 0. The transmission loss at a frequency of 67 GHz is preferably -4.20 dB/100 mm or more, more preferably -4.00 dB/100 mm or more, and still more preferably -3.30 dB/100 mm or more.

The present disclosure is also an antenna formed of the circuit board described above. In particular, it is suitable for use as a millimeter wave antenna for mobility applications such as automobiles and aircraft.

The laminate for circuit boards may be stacked with a copper foil layer, the aforementioned fluororesin sheet, and further a substrate layer.

In the laminate described above, the order of stacking the copper foil layer, the substrate, and the aforementioned fluororesin sheet, and a method for producing the laminate are not limited, and a layer configuration according to the purpose can be adopted.

In terms of the aforementioned stacking order, specific examples of the layer configuration include a layer configuration of a substrate layer/fluororesin sheet/copper foil layer, a layer configuration of a copper foil layer/fluororesin sheet/substrate layer/fluororesin sheet/copper foil layer, and a layer configuration of a copper foil layer/substrate layer/fluororesin sheet/substrate layer/copper foil layer.

Also, a layer configuration with another layer may be included, if necessary.

### Examples

The present disclosure will be specifically described below based on Examples. However, the present invention is not limited to the following Examples. In the following Examples, "parts" and "%" represent "parts by mass" and "% by mass," respectively, unless otherwise specified.

Each sample obtained was evaluated based on the following criteria.

### [Thickness of fluororesin sheet]

The thickness was measured using a micrometer gauge.

### [XPS measurement of fluororesin sheet surface]

The surface was measured using a scanning X-ray photoelectron spectroscopy apparatus (XPS/ESCA) PHI5000VersaProbeII (manufactured by ULVAC-PHI, INCORPORATED)

### [Coefficient of linear expansion (CTE)]

The coefficient of linear expansion was determined by making a TMA measurement in tensile mode using a TMA-7100 (manufactured by Hitachi High-Tech Science Corporation), using a fluororesin sheet cut to a length of 20 mm, width of 5 mm, and thickness of 150 µm as a sample piece, setting a chuck distance to 10 mm, and measuring the amount of sample displaced while applying a load of 49 mN, at 0 to 150°C (rate of temperature rise of 2°C/min).

### [Dielectric constant and dielectric loss tangent of fluororesin sheet]

The dielectric constant and dielectric loss tangent at 25°C and 10 GHz were measured using a split-cylinder type dielectric constant/dielectric loss tangent measurement apparatus (manufactured by EM Labs, Inc.).

### [Static contact angle of water]

Regarding the static contact angle of water of the fabricated fluororesin sheet, the static contact angle of water was measured using a contact angle meter ("DropMaster" manufactured by Kyowa Interface Science Co., Ltd.), as a contact angle against water at 23°C, 1 second after a droplet of a volume of 2 µL had been dropped on the surface.

### [Peel strength]

Copper foil (CF-T9DA-SV-18 with Rz = 0.85 µm and Rq = 0.05 µm, manufactured by Fukuda Metal Foil Powder Co., Ltd.) was overlapped on top and bottom of the fluororesin sheet after surface treatment so that a surface-treated surface of the copper foil closely adhered to the fluororesin sheet, and they were thermocompressed by a vacuum heat press (360°C, 2.5 MPa, and 300 s) to fabricate a sample.

The obtained sample was cut into a strip with a width of 10 mm, and a Tensilon universal testing machine (manufactured by Shimadzu Corporation) was used to measure peel strength by pulling a portion not adhering to the copper foil, of the strip sample at a speed of 50 mm per minute while being held with the top and bottom chucks of the Tensilon, then to take the obtained value as the peel strength.

### <Method of fabricating sheets A to G>

### (Paste extrusion forming)

PTFE powder (average particle size: 500 µm, apparent density: 460 g/L, and standard specific gravity: 2.17) and the silica particle shown in Table 1 were weighed and mixed in the mass ratio shown in Table 1 in a mixer in the presence of dry ice. The temperature during mixing was -10°C or lower.

Oil (Isopar H) was added to the obtained mixed powder in a concentration of 18 to 23%, mixed, and aged for approximately 5 hours.

The aged composition was preliminarily formed under the conditions of a pressure of 3 MPa, and the preformed article was extruded under the conditions of 40°C and 50 mm/min to obtain an extruded sample.

The extruded sample was rolled with two rolls to obtain a sample with a film thickness of 125 µm, which was then passed through a drying roll at 200°C and dried.

Furthermore, adjustment of gap and pressure of the two rolls was carried out to confirm fabricationability of sample with a film thickness of 30 µm.

### <Method of fabricating sheet H>

### (Powder rolling forming)

PTFE powder (average particle size: 500 µm, apparent density: 460 g/L, and standard specific gravity: 2.17) and the silica particle shown in Table 1 were weighed in the mass ratio shown in Table 1, and stirred twice for 30 seconds at room temperature with a Wonder Crusher at setting 6.

The resulting mixture was rolled with two rolls (the roll gap was set to 100 µm and the roll temperature was 100°C) to obtain a sample with a film thickness of 130 µm.

It is to be noted that the silica used in each Example was spherical silica, as shown in Table 1, i.e., SC6500-SQ (average particle size: 2.1 µm) manufactured by Admatechs Co., Ltd. and SC6500-SQ (average particle size: 2.1 µm) manufactured by Admatechs Co., Ltd., which were surface treated with 3-aminopropyltriethoxysilane (treatment amount of 0.5% by mass or 1% by mass relative to the mass of the silica particle).

**[Table 1]**

| Sheet | Fluororesin | Silica | Silica surface treatment | Fluororesin:Silica (mass ratio) |
|---|---|---|---|---|
| A | PTFE | SC6500-SQ | 3-aminopropyltriethoxysilane 1% | 40:60 |
| B | PTFE | SC6500-SQ | 3-aminopropyltriethoxysilane 0.5% | 40:60 |
| C | PTFE | SC6500-SQ | 3-aminopropyltriethoxysilane 1% | 50:50 |
| D | PTFE | SC6500-SQ | None | 40:60 |
| E | PTFE | SC6500-SQ | 3-aminopropyltriethoxysilane 1% | 80:20 |
| F | PTFE | SC6500-SQ | 3-aminopropyltriethoxysilane 1% | 90:10 |
| G | PTFE | SC6500-SQ | 3-aminopropyltriethoxysilane 1% | 95:5 |
| H | PTFE | SC6500-SQ | 3-aminopropyltriethoxysilane 1% | 40:60 |

### (Examples 1 to 10)

### (Surface treatment of fluororesin sheet)

The fluororesin sheet was arranged between upper and lower electrodes in a processing chamber (direct type plasma surface treatment apparatus, manufactured by Air Water Inc.) equipped with the upper electrode and the lower electrode, and the processing chamber was filled with the following mixed gas atmosphere, after which discharge plasma treatment was performed on a surface of the fluororesin sheet for the processing time shown in Table 2.

### (Processing atmosphere)

A: Mixed gas of argon, helium, and oxygen
B: Mixed gas of argon, helium, nitrogen, and oxygen

The composition of each element of the surface-treated fluororesin sheet was measured by XPS.

### (Comparative Example 1)

Sheet A was not surface treated, and the composition of each element was measured by XPS.

### (Comparative Examples 2 to 4)

Discharge plasma treatment was performed on a surface of the fluororesin sheet in the same manner as in Example 5, except that Sheets E to G were used.

The composition of each element of the surface-treated fluororesin sheet was measured by XPS.

The results of Examples 1 to 10 and Comparative Examples 1 to 4 are shown in Table 2.

**[Table 2]**

| | Sheet | Treatment atmosphere | Treatment time (second) | Elemental composition by XPS measurement (atomic%) | | | | | Dielectric constant | Dielectric loss tangent | Physical property value | | |
|---|---|---|---|---|---|---|---|---|---|---|---|---|---|
| | | | | C1s | N1s | O1s | F1s | Si2p | | | CTE | Static contact angle of water (°) | Peel strength (kN/m) |
| Example 1 | A | A | 18 | 50.0 | 0.1 | 10.1 | 37.8 | 2.0 | 2.7 | 0.0006 | 35 | 105 | 0.6 |
| Example 2 | A | A | 36 | 58.3 | 0.1 | 15.6 | 23.5 | 2.6 | 2.7 | 0.0006 | 35 | 104 | 0.5 |
| Example 3 | A | A | 72 | 73.1 | 0.0 | 17.9 | 8.8 | 0.8 | 2.7 | 0.0006 | 35 | 100 | 0.5 |
| Example 4 | A | B | 18 | 41.7 | 1.8 | 5.5 | 48.9 | 2.2 | 2.7 | 0.0006 | 35 | 100 | 1.4 |
| Example 5 | A | B | 36 | 45.1 | 4.3 | 9.0 | 38.5 | 3.1 | 2.7 | 0.0006 | 35 | 95 | 1 |
| Example 6 | A | B | 72 | 53.6 | 5.0 | 12.3 | 24.5 | 4.6 | 2.7 | 0.0006 | 35 | 96 | 1.2 |
| Example 7 | B | B | 36 | 39.0 | 1.2 | 5.0 | 53.2 | 1.6 | 2.8 | 0.0007 | 37 | 97 | 0.9 |
| Example 8 | C | B | 36 | 44.8 | 2.9 | 5.2 | 46.0 | 1.1 | 2.5 | 0.0006 | 68 | 100 | 0.9 |
| Example 9 | D | B | 36 | 44.4 | 2.8 | 7.9 | 42.3 | 2.6 | 2.8 | 0.001 | 40 | 102 | 0.7 |
| Example 10 | H | B | 36 | 45.1 | 4.2 | 8.8 | 39.1 | 3.0 | 2.7 | 0.0006 | 39 | 97 | 0.8 |
| Comparative Example 1 | A | - | 0 | 36.2 | 0.3 | 1.9 | 60.7 | 0.9 | 2.7 | 0.0006 | 35 | 123 | <0.1 |
| Comparative Example 2 | E | B | 36 | 37.8 | 0.5 | 1.3 | 60.3 | 0.0 | 2.4 | 0.0004 | 157 | 110 | <0.1 |
| Comparative Example 3 | F | B | 36 | 37.5 | 0.1 | 1.5 | 60.9 | 0.0 | 2.4 | 0.0003 | 178 | 109 | <0.1 |
| Comparative Example 4 | G | B | 36 | 39.7 | 1.2 | 1.6 | 57.5 | 0.1 | 2.3 | 0.0003 | 190 | 112 | <0.1 |

### [Metal interface electrical conductivity measurement]

Copper foil (CF-T9DA-SV-18 manufactured by Fukuda Metal Foil Powder Co., Ltd.) was overlapped on top and bottom of the fluororesin sheet fabricated in Example 5 so that a surface-treated surface of the copper foil closely adhered to the sheet, inserted into a vacuum heat press, raised from room temperature to 360°C under vacuum, and pressed at a pressure of 3 MPa at 360°C to fabricate a double-sided copper-clad laminate board. Using the double-sided copper-clad laminate board fabricated, a circular dielectric sample (with no copper on both sides) and a circular dielectric sample (with circular copper foil patterned on one side of the sample) were fabricated, and the metal layer interface electrical conductivity (1e7 S/m) was measured in the frequency range of 14.5 GHz to 111.5 GHz using a balanced-type disk resonator method. The average of metal layer interface electrical conductivity of the double-sided copper-clad laminated board fabricated in Example 5 was 5.66 (1e7 S/m), which had the same result as a standard copper disk.

Also, metal layer interface electrical conductivity was measured in the same manner using a commercially available RO3003 (manufactured by Rogers Corporation), which was a double-sided copper-clad laminated board made of a composite sheet of a fluororesin and a filler, the average of which was 0.56 (1e7 S/m).

Therefore, it has been clarified that the double-sided copper-clad laminated board using the sheet fabricated in Example 5 has higher metal interface electrical conductivity than the commercially available double-sided copper-clad laminated board.

### [Transmission loss measurement]

Copper foil (CF-T9DA-SV-18 with Rz = 0.85 µm, manufactured by Fukuda Metal Foil Powder Co., Ltd.) was overlapped on top and bottom of the fluororesin sheet fabricated in Example 5 so that a surface-treated surface of the copper foil closely adhered to the fluororesin sheet, inserted into a vacuum heat press, raised from room temperature to 360°C under vacuum, and pressed at a pressure of 3 MPa at 360°C to fabricate a double-sided copper-clad laminate board.

In order to form a transmission line on the double-sided copper-clad laminate board fabricated, a microstrip line was used. The 50 and 68 GHz signals on the printed circuit board were processed using a network analyzer ("E8361A" manufactured by Keysight Technologies Inc.), and a S21 parameter indicating a transmission loss, was measured using a Universal Test Fixture as a probe. In this case, characteristic impedance of the line was set to 50 Ω, and a length of the transmission line on the printed circuit board was set to 100 mm, and then the transmission loss was measured.

As a measure of the transmission loss, the "S21-parameter," which was one of the circuit network parameters used to represent characteristics of high-frequency electronic circuits and high-frequency electronic components was used, and it was used as the transmission loss value. This value means that the closer to 0 the value is, the smaller the transmission loss is.

The transmission loss was -2.42 dB/100 mm at a frequency of 50 GHz and -2.96 dB/100 mm at a frequency of 67 GHz.

Also, the measurement of transmission loss made in the similar manner using a commercially available RO3003G2 (manufactured by Rogers Inc.), which was a double-sided copper-clad laminated board made of a composite sheet of a fluororesin and a filler, demonstrated that the transmission loss was -3.47 dB/100 mm at a frequency of 50 GHz and -4.53 dB/100 mm at a frequency of 67 GHz.

Therefore, it has been revealed that the double-sided copper-clad laminated board using the fluororesin sheet fabricated in Example 5 has a lower transmission loss than the commercially available double-sided copper-clad laminated board.

All the experimental results described above show that the fluororesin sheets of the Examples have a low CTE and can favorably adhere to copper foil with a high smoothness, and the laminates with copper foil with a high smoothness have high metal interface electrical conductivity and a low transmission loss, making it suitable for use as a material for a substrate for circuits.

### Industrial Applicability

The fluororesin sheet of the present disclosure can be suitably used for copper-clad laminated boards for circuit boards.

## Claims

1. A fluororesin sheet comprising a fluororesin and a silica particle, wherein one or both surfaces of the fluororesin sheet have an oxygen element percentage of 3.0 atomic% or more as measured by X-ray photoelectron spectroscopy (XPS), and the fluororesin sheet has a coefficient of linear expansion (CTE) of 100 ppm/°C or less.

2. The fluororesin sheet according to claim 1, wherein the fluororesin is polytetrafluoroethylene.

3. The fluororesin sheet according to claim 1 or 2, wherein the same surface thereof further has a nitrogen element percentage of 1.35 atomic% or more as measured by X-ray photoelectron spectroscopy (XPS).

4. The fluororesin sheet according to any one of claims 1 to 3, wherein the same surface thereof further has a silicon element percentage of 0.5 atomic% or more as measured by X-ray photoelectron spectroscopy (XPS).

5. The fluororesin sheet according to any one of claims 1 to 4, wherein the same surface thereof further has a static contact angle of water of 105° or less, measured 1 second after a droplet of a volume of 2 µL has been dropped on the surface.

6. The fluororesin sheet according to any one of claims 1 to 5, wherein the silica particle is spherical silica.

7. The fluororesin sheet according to any one of claims 1 to 6, wherein, as the silica particle, a silica particle treated with a silane coupling agent is used.

8. The fluororesin sheet according to any one of claims 1 to 7, wherein the silica particle has an average particle size of 10 µm or less.

9. The fluororesin sheet according to any one of claims 1 to 8, being free of a glass fiber.

10. The fluororesin sheet according to any one of claims 1 to 9, wherein a content of the silica particle relative to a total amount of the fluororesin sheet is 30% by mass or more.

11. The sheet according to any one of claims 1 to 9, wherein a content of the silica particle relative to a total amount of the fluororesin sheet is 50% by mass or more.

12. The sheet according to any one of claims 1 to 9, wherein a content of the silica particle relative to a total amount of the fluororesin sheet is 50% by mass or more and 65% by mass or less.

13. The fluororesin sheet according to any one of claims 1 to 12, having a dielectric loss tangent at 10 GHz of 0.0015 or less.

14. The fluororesin sheet according to any one of claims 1 to 13, having a thickness of 5 to 250 µm.

15. A method for producing the fluororesin sheet according to any one of claims 1 to 14, comprising mixing a fluororesin particle and a silica particle to form a film, followed by surface treatment thereof.

16. The method for producing the fluororesin sheet according to claim 15, comprising forming a film by using a composition substantially composed of a fluororesin particle and a filler particle containing at least a silica particle, followed by surface treatment thereof.

17. A copper-clad laminate comprising copper foil and the fluororesin sheet according to any one of claims 1 to 14 as essential layers.

18. The copper-clad laminate according to claim 17, wherein the copper foil has a surface roughness (Rz) of 2.0 µm or less.

19. The copper-clad laminate according to claim 17 or 18, wherein the copper foil has a surface roughness (Rq) of 0.01 to 0.15 µm.

20. The copper-clad laminate according to any one of claims 17 to 19, wherein the copper foil is directly stacked on the fluororesin sheet, and peel strength of an interface between the copper foil and the fluororesin sheet is 0.5 kN/m or more.

21. A method for producing the copper-clad laminate according to any one of claims 17 to 20, comprising stacking the fluororesin sheet according to claim 1 and copper foil, heating the stack at 180 to 390°C, and press forming the stack at a pressure of 0.5 to 5 MPa under vacuum or in an inert gas atmosphere.

22. A substrate for circuits, having the copper-clad laminate according to any one of claims 17 to 20.

23. An antenna formed of the substrate for circuits according to claim 22.

24. The antenna according to claim 23, being a millimeter wave antenna for mobility applications.
